# EUROPÄISCHE PATENTSCHRIFT

(11) **EP 1 735 819 B1**
(45) Veröffentlichungstag und Bekanntmachung des Hinweises auf die Patenterteilung: **09.06.2010**
(21) Anmeldenummer: 05738775.5
(22) Anmeldetag: 31.03.2005
(51) Int. Cl.: H01L 21/00

(54) **VERFAHREN ZUR REINIGUNG UND ÄTZUNG EINES SUBSTRATES MIT EINER TRANSPARENTEN, LEITFÄHIGEN OXIDSCHICHT SOWIE VORRICHTUNG ZUR DURCHFÜHRUNG DES VERFAHRENS**
PROCESS AND DEVICE FOR CLEANING AND ETCHING A SUBSTRATE WITH A TRANSPARENT CONDUCTIVE OXIDE LAYER
PROCEDE POUR NETTOYER ET GRAVER UN SUBSTRAT DOTE D'UNE COUCHE D'OXYDE CONDUCTEUR TRANSPARENT ET DISPOSITIF POUR REALISER CE PROCEDE

(30) Priorität: 10.04.2004 DE 102004017680
(43) Veröffentlichungstag der Anmeldung: 27.12.2006
(73) Patentinhaber: Forschungszentrum Jülich GmbH, 52425 Jülich (DE)
(72) Erfinder: MÜLLER, Joachim, 70736 Fellbach (DE); SCHÖPE, Gunnar, 52441 Linnich (DE); SIEKMANN, Hildegard, NL-6461 HH Kerkrade (NL); RECH, Bernd, 52070 Aachen (DE); REPMANN, Tobias, 63755 Alzenau (DE); APENZELLER, Wolfgang, 52445 Titz (DE); SEHRBROCK, Brigitte, 52428 Jülich (DE)
(86) Internationale Anmeldenummer: PCT/DE2005/000563
(87) Internationale Veröffentlichungsnummer: WO 2005/101522

(56) Entgegenhaltungen:
- DE-A1- 19 600 985
- DE-A1- 19 713 215
- DE-A1- 19 908 960
- MULLER J ET AL: "Upscaling of texture-etched zinc oxide substrates for silicon thin film solar cells" THIN SOLID FILMS, ELSEVIER-SEQUOIA S.A. LAUSANNE, CH, Bd. 392, Nr. 2, 30. Juli 2001 (2001-07-30), Seiten 327-333, XP004250761 ISSN: 0040-6090

## Beschreibung

Die Erfindung betrifft ein Verfahren zur Reinigung und Ätzung eines Substrates, welches eine transparente und leitfähige Oxydschicht (TCO) Schicht aufweist, insbesondere eine Zinkoxidschicht, wie sie bei der Herstellung von Solarmodulen verwendet wird. Ferner betrifft die Erfindung eine geeignete Vorrichtung zur Durchführung des vorgenannten Verfahrens.
Aus DE 199 08 960 A1 ist eine Vorrichtung und ein Verfahren zum Ätzen metallischer Schichten, wie Leiterplatten bekannt.
DE 197 13 215 A1 offenbart ein Ätzverfahren für TCO- Schichten.
Aus DE 196 00 985 A1 ist ein Verfahren und eine Vorrichtung zum Behandeln von Substraten bekannt.

### Weiterer Stand der Technik

Die Herstellung von Silizium-Dünnschichtsolarmodulen auf der Basis von amorphem oder mikrokristallinem Silizium bzw. deren Legierungen macht unter anderem eine Strukturierung des vorderseitigen TCO ("transparent conductive oxide")-Kontakts erforderlich. Diese Strukturierung erfolgt in der Regel fast ausschließlich mit Hilfe der Laserablation, wodurch auf der Oberfläche Schichtreste als Rückstände zurückbleiben. Diese müssen vor der weiteren Beschichtung auf der gesamten Substratfläche entfernt werden, die für eine industrielle Modulproduktion in der Größenordnung von 1 m² liegt. Es ist somit in jedem Fall ein Reinigungsschritt notwendig. Die vollkommene Auftrennung der TCO-Schicht ist kritisch für die Funktionsweise des Bauelementes und zwingend notwendig für eine hohe Ausbeute.
Bei der industriellen Modulfertigung mit Substratgrößen um 1 m² ist die Reinigung in der Regel ein notwendige und eigenständiger Prozessschritt, der nach der Laserstrukturierung des TCO und vor Aufbringen der weiteren Schichten erfolgt. Eine der technischen Umsetzungen, die hierfür eingesetzt werden, ist beispielsweise eine Bürstenwasektanlage.
Bei Verwendung von durch Magnetronsputtern hergestelltem Zinkoxid (ZnO) als TCO-Material muss in der Regel zusätzlich eine Aufrauung der Schichtoberfläche erfolgen, um eine ausreichende Streuung des einfallenden Sonnenlichts zu gewährleisten. Diese Aufrauung erfolgt am einfachsten durch nasschemischen Ätzen in verdünnter Säure oder Lauge. Texturiertes Zinkoxid als frontseitiges TCO-Material wird bisher in der Produktion von Si-Dünnschichtsolarmodulen nicht eingesetzt. Daher existiert bisher auch keine großtechnische Lösung für den nass-chemischen Ätzschritt.

Bei der kleinflächigen Solarzellen- und Solarmodulherstellung im Labormaßstab mit typischen Substratgröße von 10 x 10 cm² wird im Institut für Photovoltaik in der Forschungszentrum Jülich GmbH durch Magnetron-Sputtern hergestelltes und nasschemisch texturiertes ZnO als frontseitiges TCO-Material eingesetzt. Bei der Herstellung von Solarmodulen auf einer Substratfläche von bis zu 10 x 10 cm² erfolgt dabei die Reinigung nach der Laserstrukturierung in Kombination mit der nasschemischen Texturierung als ein Prozessschritt. Dabei werden die mit ZnO beschichteten Substrate manuell für einige 10 Sekunden in verdünnte (ca. 0,5 %-ige) Salzsäurelösung bei Raumtemperatur eingetaucht. Die genaue Temperatur wird dabei überhaupt nicht, die Ätzzeit nur manuell kontrolliert. Die Trocknung erfolgt durch manuelles Abblasen mit sauberem, trockenem Stickstoff.

Dieser vorgenannte manuelle Ätzprozess hat insbesondere folgende Nachteile:
- Die manuelle Durchführung führt zu unvermeidlichen, d. h. beispielsweise Operatorabhängigen Unreproduzierbarkeiten und Fehlern.
- Die bisherige Vorgehensweise ist nicht ohne weiteres von 10 x 1 0 cm² auf größere Substratflächen aufskalierbar, da das manuelle Eintauchen praktisch unvermeidlich zu einem inhomogenen Ätzergebnis auf großer Fläche führt.
- Die bisherige Vorgehensweise erlaubt nur einen geringen Durchsatz und lässt sich nur schwer automatisieren. Dies würde in einer industriellen Fertigung nachteilig zu hohen Kosten führen.

### Aufgabe und Lösung

Die Aufgabe der Erfindung ist es, ein Verfahren bereitzustellen, mit dem ZnO-Schichten sowohl gereinigt werden können als auch die Linientrennung nach einer Strukturierung der Schicht zusammen mit der nasschemischen Aufrauung der Schicht mit möglichst geringem prozesstechnischem und zeitlichem Aufwand reproduzierbar homogen auf großer Fläche, d. h. in der Regel 1 m² oder größer realisiert werden kann. Ferner ist es die Aufgabe der Erfindung ein besonders vorteilhaftes Verfahren zu schaffen, bei dem sich an die vorgenannte Ätzung und Reinigung direkt die Trocknung der geätzten Scheiben anschließen lässt.
Die Aufgaben der Erfindung werden gelöst durch ein Verfahren gemäß Hauptanspruch 12 sowie durch eine Vorrichtung zur Durchführung des genannten Verfahrens gemäß Nebenanspruch 1. Vorteilhafte Ausführungsformen des Verfahrens und der Vorrichtung finden sich in den jeweils darauf rückbezogenen Ansprüchen.

### Gegenstand der Erfindung

Die Erfindung erlaubt vorteilhaft eine Kombination der Reinigung und Ätzung von laserstrukturierten ZnO- Schichten auf unterschiedlichen starren oder flexiblen Trägermaterialien, wie beispielsweise Glas oder Kunststofffolie, für großflächige Substrate in einem einzigen Prozessschritt. Der Erfindung schließt sich eine zusätzliche Trocknung der Substrate derart an, dass die gesamte in folgenden Prozessschritten zu beschichtende Oberfläche des Substrates während des Trocknungsprozesses mit keinerlei Materialien wie z. B. Transportrollen in Berührung kommt.

Die Erfindung betrifft ein Verfahren, bei dem das Reinigen und das notwendige Ätzen vorteilhaft in einem einzigen Prozessschritt durchgeführt werden kann, indem eine Vorrichtung zum Reinigen/Ätzen in Form einer Durchlauf-Sprühätzanlage eingesetzt wird. Die Substratgröße unterliegt dabei keiner grundsätzliche Beschränkung. Das auf einem Träger angeordnete ZnO kann auf der gesamten Substratfläche homogen und mit genau einstellbarer Ätzzeit aufgeraut, gespült und somit auch gereinigt und vorteilhaft auch sofort getrocknet werden.

Bei der zur Durchführung des Verfahrens geeigneten erfindungsgemäßen Vorrichtung handelt es sich um eine Durchlaufätzanlage, bei der ein großflächiges ZnO-beschichtetes Substrat von einem Einlaufbereich durch Ätz-, Spül- und Trockenkammern hindurch zu einem Auflaufbereich transportiert wird. Die Ätz- bzw. Spüllösung wird dabei insbesondere durch Sprühdüsen aufgebracht. Der Transport kann vorteilhaft mittels eines Systems aus säure- und laugebeständigen Transportrollen erfolgen.

Im folgenden wird der erfindungsgemäße Prozessablauf systematisch beschrieben.
- Prozessschritt 1.: Benetzung des TCO beschichteten Substrats mit hochreinem Wasser.
- Zweck:: Sofortige Verdünnung von möglicherweise ungewollt nach unten tropfendem Ätzmittel im dem nachfolgenden Ätzschritt.
- Prozessschritt 2.: Aufsprühen der Ätzlösung.
- Zweck:: Homogenes Aufbringen des Ätzmittels auf die gesamte Substratfläche.
- Prozessschritt 3.: Spülen des Substrats mit Wasser oder einer Spüllösung.
- Zweck:: Rasches Entfernen des Ätzmittels zum sofortigen Beenden des Ätzprozesses.
- Prozessschritt 4.: Gegebenenfalls ein- oder mehrmalige Wiederholung von Prozessschritt 3.
- Zweck:: Verbessertes Spülergebnis. Bemerkung zu Prozessschritten 3 und 4: Für eine rückstandsfreie Substratoberfläche ist es von Vorteil, das gespülte Substrat bis direkt vor Beginn des Trockenprozesses mit Spüllösung benetzt zu halten, um nachteilige Eintrocknung von Spüllösungsresten zu vermeiden.

Die Erfindung sieht darüber hinaus noch einen weiteren Prozessschritt 5 vor, in dem das Substrat getrocknet wird. Das Ziel ist eine homogene, rückstandsfreie Entfernung sämtlicher Reste des Spülmediums für eine ggfs. sich direkt an diesen Prozessschritt anschließende Beschichtung.

In einer vorteilhaften Ausgestaltung der Erfindung ist die Temperatur des Ätzmittels einstell- und regelbar. Für reproduzierbare Ätzergebnisse kann zusätzlich vor der Ätzung die Leitfähigkeit des Ätzmediums bestimmt und bei Abweichung vom Sollwert neu eingestellt werden. Die Art des Ätzmediums ist im Rahmen der Beständigkeit der verwendeten Materialien von einem Fachmann frei wählbar und kann an die Anforderungen des Prozesses angepasst werden. Die gesamte Anlage ist säuren- und laugenbeständig ausgeführt und sollte über mindestens eine Absaugöffnung zur Absaugung von Dämpfen verfügen. Die Transportgeschwindigkeit des Substrats ist in einer vorteilhaften Ausführung der Vorrichtung stufenlos einstellbar und dient somit zur genauen Kontrolle der Ätzzeit. Die Schichteigenschaften werden direkt vor und direkt nach dem Prozess bestimmt. Das Ergebnis der Schichtcharakterisierung wirkt über eine Regelschleife automatisch auf die Ätzbedingungen, insbesondere die Substratgeschwindigkeit (d. h. Ätzzeit), zurück, so dass ein gleich bleibendes Ätzergebnis garantiert werden kann.

Die Trocknung des Substrates kann ebenfalls in einer Durchlaufanlage beispielsweise mittels jeweils eines oben und unten in geringem Abstand zum Substrat angebrachten Luftmessers erfolgen. Ein entsprechend eingestellter Anblaswinkel und Luftdruck oberhalb und unterhalb des Substrates sorgen dafür, dass die gesamte zu beschichtende Oberfläche während des Trocknungsprozesses mit keinerlei Materialien wie beispielsweise den Transportrollen in Berührung kommt, aber ein störungsfreier Weitertransport gewährleistet bleibt.

### Spezieller Beschreibungsteil

Nachfolgend wird der Gegenstand der Erfindung anhand von Figuren näher erläutert, ohne dass der Gegenstand der Erfindung dadurch beschränkt wird.
Als Ausführungsbeispiel wurde eine bestehende Ätzapparatur aus dem Bereich der Leiterplattenfertigung für den erfindungsgemäßen Zweck (Ätzen von mit ZnO beschichteten großflächigen Substraten) modifiziert. In der in der Forschungszentrum Jülich GmbH vorhandenen Demonstrationsanlage können Substrate mit einer Fläche bis zu 40 x 40 cm²verwendet werden. In dem vorgenannten Ausführungsbeispiel sehen diese Modifikationen folgendermaßen aus:
- Die Anlage ist als Horizontalanlage mit waagrechter Lage der Transportrollen und horizontalem Substrattransport ausgeführt.
- Die Benetzung (Prozessschritt 1) erfolgt manuell außerhalb der Apparatur. Als Ätzmittel wird 0,5 %-ige Salzsäure (HCl) verwendet.
- Das Ätzmittel befindet sich vor und nach dem Gebrauch der Anlage in einem vollkommen geschlossenen Behälter. So wird ein Verdampfen des Ätzmittels verhindert, solange kein Prozess läuft.
- Die Geschwindigkeit lässt sich mit großer Genauigkeit und Reproduzierbarkeit mittels eines digitalen Reglers einstellen.
- Im ersten Spülschritt (erste Spülkammer) wird vollentsalztes Wasser, in der zweiten Spülkammer deionisiertes Wasser aufgesprüht.
- Sämtliche Teile, die mit der Ätzlösung in Kontakt kommen, einschließlich der Trockenvorrichtung sind aus säurebeständigem Kunststoff oder aus Titan gefertigt.
- Titanschienen an den Seiten verhindern ein Steckenbleiben von scharfkantigen Glassscheiben.
- Durch Verwendung entsprechender Keile sind Substratdicken variabel zwischen 1 und 4 mm wählbar.

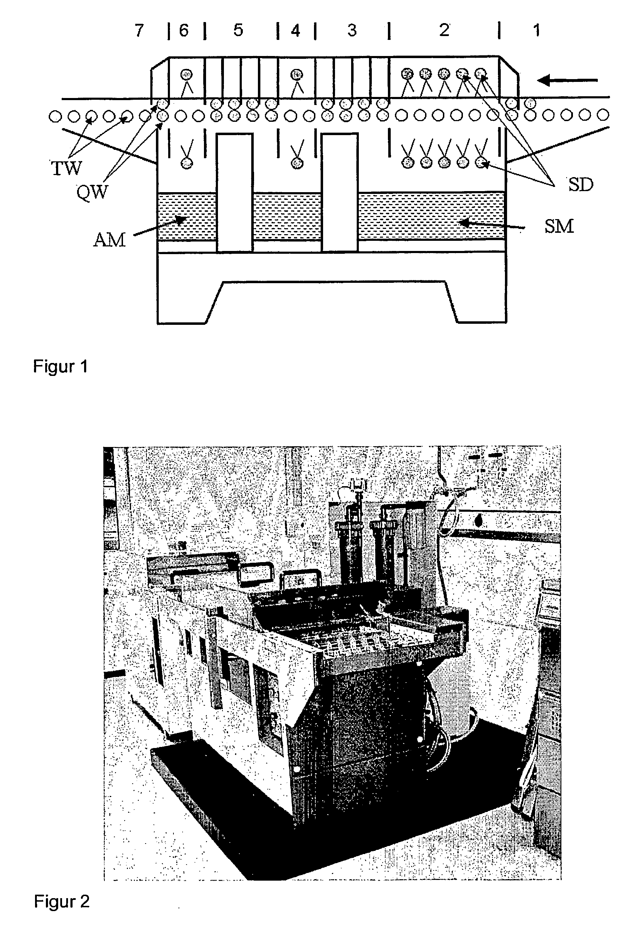

- Figur 1:: Skizze des im Forschungszentrum Jülich GmbH vorhandenen Ausführungsbeispiels einer Durchlaufätzanlage mit
1 = Einlaufzone;
2 = Ätzzone;
3, 5 = Abquetschzonen;
4, 6 = Spülzonen;
7 = Auslaufzone
AM = Ätzmittel; SM = Spülmittel; SD = Sprühdüsen;
TW = Transportwalzen, QW = Quetschwalzen
- Figur 2:: Photographie der in der Forschungszentrum Jülich GmbH vorhandenen Demonstrationsanlage einer Durchlaufätz-(vorne) und Durchlauftrockenanlage (hinten). Die Durchlaufanlage befindet sich noch in der Entwicklung und wird laufend optimiert.

Die derzeitige Demonstrationsanlage ist recht flexibel, und kann Substratgrößen von 10x10 cm² bis 40x40 cm² aufnehmen. Eine Anpassung an weitere Größen ist problemlos möglich. Bei dem Einsatz fester Substratgröße ist denkbar, dass schmale Transportrollen nur am Rand der Kammern angebracht sind und somit auch nur am Rand des ZnO/Glas-Substrats mit diesem in Berührung kommen. Dies wäre von Vorteil, da dadurch das Glas auch auf der Unterseite keinerlei Kontakt mit einem Transportsystem hat und damit ideal wenig potentiell verunreinigt bzw. beeinflusst wird. Für einen Einsatz von flexiblen Substraten ist auch ein sogenannter Roll-to-Roll-Prozess vorstellbar, bei dem statt Glassubstraten eine flexible mit ZnO beschichtete Folie (Metall, Kunststoff) verwendet wird, die auf der Eingangsseite der Vorrichtung von einer Rolle abgewickelt, und am Ausgang wieder aufgewickelt wird. Dazu sollte aber die Folie vorteilhaft bereits getrocknet sein.

Die horizontale Lage des Substrates in der Anlage ist dabei keine zwingende Voraussetzung. Eine vertikale Anordnung kann sogar vorteilhaft sein, da dann z. B. herabtropfendes Ätzmittel nicht direkt auf das ZnO/Glass-Substrat treffen würde. Auf der anderen Seite hat die vertikale Lage den Nachteil, dass das Ätz- und Spülmittel einfach aufgrund der Schwerkraft auf dem Substrat nach unten laufen wird und daher möglicherweise die Homogenität des Ätzprozesses beeinträchtigt. Bei der horizontalen Lage verteilt sich das Ätzmittel in der Regel gleichmäßig und wird auch gleichmäßig abgespült.

Auch das vorgenannte Aufsprühen der Lösungen auf das Substrat ist nicht zwingend erforderlich. Sprühdüsen sind aber in der Regel sehr effizient, einfach und kostengünstig. Denkbar und geeignet im Sinne der Erfindung sind aber auch die folgenden beiden Alternativen.
A: Das Substrat durchläuft ein großflächiges Ätz- und Spülbad, in dem sich das Ätz- bzw.-Spülmittel befindet. Als Nachteil könnte dabei genannt werden, dass der Prozess von der Ätzzeit her schwerer zu kontrollieren ist. Kürzere Ätzzeiten in einem Bereich von weniger als 20 - 40 s sind regelmäßig schwieriger einzustellen. Ferner ist eine solche Halterung mechanisch aufwändiger, da das Substrat beim Ein- und Ausfahren aus den Becken auch vertikale Höhenunterschiede überwinden muss.
B: Man lässt einen Säurefilm auf der gesamten Breite von oben auf das Substrat laufen. Auch hier ist mit einer schwierigeren technischen Umsetzung, Kontrolle und Reproduzierbarkeit zu rechnen.

## Patentansprüche

1. Vorrichtung zur Behandlung von Substraten, die auf starren oder flexiblen Trägem angeordnete, vorstrukturierte Zinkoxidschichten aufweisen, mit einem ersten Mittel zum Behandeln des Substrates mit einer Ätzflüssigkeit, einem zweiten Mittel zum Behandeln des Substrates mit Reinigungsflüssigkeit und einem weiteren Mittel zum Transport des Substrates von dem ersten zum zweiten Mittel, sowie einem Mittel zum Trocknen des Substrates nach der Reinigungsbehandlung
**dadurch gekennzeichnet, dass**
es sich bei der Vorrichtung um eine Durchlaufanlage handelt, die in Abhängigkeit vom gewählten Ätzmedium beständige Materialien aufweist.

2. Vorrichtung nach Anspruch 1,
**dadurch gekennzeichnet, dass**
sämtliche Teile, die mit Ätzlösung in Kontakt kommen, aus säurebeständigem Kunststoff oder aus Titan gefertigt sind.

3. Vorrichtung nach einem der vorhergehenden Ansprüche,
**dadurch gekennzeichnet, dass**
die gesamte Vorrichtung säure- und laugenbeständig ausgeführt ist.

4. Vorrichtung nach einem der vorhergehenden Ansprüche,
mit Transportrollen als einem weiteren Mittel.

5. Vorrichtung nach einem der vorhergehenden Ansprüche,
mit einem Antrieb, der die Transportrollen anzutreiben vermag.

6. Vorrichtung nach einem der vorhergehenden Ansprüche,
welches Substrate mit einer Zinkoxidfläche von mehr als 0,16 m², insbesondere von mehr als 0,5 m² zu behandeln vermag.

7. Vorrichtung nach einem der vorhergehenden Anspruch,
bei dem die Transportrollen derart angeordnet sind, dass sie ein Substrat horizontal zu transportieren vermögen.

8. Vorrichtung nach einem der vorhergehenden Ansprüche,
mit einer oder mehreren Sprühdüsen als ein erstes oder ein zweites Mittel.

9. Vorrichtung nach Anspruch 8,
bei der die Sprühdüse oberhalb der Transportrollen angeordnet ist.

10. Vorrichtung nach einem der vorhergehenden Ansprüche,
mit wenigstens einer temperierbaren Sprühdüse als erstes oder zweites Mittel.

11. Vorrichtung nach einem der vorhergehenden Ansprüche,
bei dem zwischen dem Mittel zum Behandeln des Substrates mit einer Ätzflüssigkeit und dem zweiten Mittel zum Behandeln des Substrates mit Reinigungsflüssigkeit, Walzen derart angeordnet sind, dass sie Flüssigkeiten auf der Oberfläche des Substrates abzustreifen vermögen.

12. Verfahren zur Behandlung von Substraten, die auf starren oder flexiblen Trägem angeordnete, vorstrukturierte Zinkoxidschichten aufweisen, bei dem das ZnO mit einem Ätzmedium und anschließend mit einer Reinigungsflüssigkeit behandelt und getrocknet wird, und die Behandlung mit der Ätzflüssigkeit und der Reinigungsflüssigkeit sowie die Trocknung erfolgt, während das Substrat durch eine Vorrichtung transportiert wird,
**dadurch gekennzeichnet, dass**
eine Durchlaufanlage als Vorrichtung verwendet wird, die in Abhängigkeit vom Ätzmedium beständige Materialien aufweist.

13. Verfahren nach vorhergehendem Anspruch 12,
bei dem mehrere Substrate nacheinander behandelt werden.

14. Verfahren nach einem der vorhergehenden Ansprüche 12 bis 13, bei dem das Substrat mit Hilfe von Transportrollen durch die Vorrichtung transportiert wird.

15. Verfahren nach einem der vorhergehenden Ansprüche 12 bis 14, bei dem ein Substrat mit einer vorstrukturierten Zinkoxidoberfläche von mehr als 0,16 m², insbesondere von mehr als 0,5 m² behandelt wird.

16. Verfahren nach einem der vorhergehenden Ansprüche 12 bis 15, bei dem die Behandlung des Substrates mit einem Ätzmedium und einer Reinigungsflüssigkeit mit Hilfe von Sprühdüsen erfolgt.

17. Verfahren nach einem der vorhergehenden Ansprüche 12 bis 16, bei dem das Substrat horizontal mit der TCO-Schicht nach oben durch die Vorrichtung transportiert wird, und die Behandlung mit einem Ätzmedium und einer Reinigungsflüssigkeit mit Hilfe von Sprühdüsen von oben auf die Oberfläche erfolgt.

18. Verfahren nach einem der vorhergehenden Ansprüche 12 bis 17,
bei dem das Ätzmedium und/oder die Reinigungsflüssigkeit temperiert wird bzw. werden.

19. Verfahren nach einem der vorhergehenden Ansprüche 12 bis 18, bei der eine Vorrichtung gewählt wird, bei der sämtliche Teile, die mit Ätzlösung in Kontakt kommen, aus säurebeständigem Kunststoff oder aus Titan gefertigt sind.

20. Verfahren nach einem der vorhergehenden Ansprüche 12 bis 19, bei der die gesamte Vorrichtung säure- und laugenbeständig ausgeführt ist.

## Claims

1. Device for treating substrates which have prestructured zinc oxide layers arranged on rigid or flexible supports, with a first means for treating the substrate with an etching solution, a second means for treating the substrate with a cleaning liquid and a further means for conveying the substrate from the first to the second means, as well as a means for drying the substrate following the cleaning treatment
**characterised in that**
the device is a continuous system, which has resistant materials depending on the selected etching solution.

2. Device according to claim 1,
**characterised in that**
all the parts that come into contact with the etching solution are made of acid-resistant plastic or of titanium.

3. Device according to one of the foregoing claims,
**characterised in that**
the entire device is made acid and alkali resistant.

4. Device according to one of the foregoing claims,
with transport rollers as a further means.

5. Device according to one of the foregoing claims,
with a drive which is able to drive the transport rollers.

6. Device according to one of the foregoing claims,
which is able to treat substrates with a zinc oxide layer of more than 0.16 m², particularly of more than 0.5 m².

7. Device according to one of the foregoing claims,
in which the transport rollers are arranged in such a manner that they are able to convey a substrate horizontally.

8. Device according to one of the foregoing claims,
with one or more atomiser nozzles as a first or a second means.

9. Device according to claim 8,
in which the atomiser nozzle is arranged above the transport rollers.

10. Device according to one of the foregoing claims,
with at least one temperature-controllable atomiser nozzle as the first or second means.

11. Device according to one of the foregoing claims,
in which cylinders are arranged between the means for treating the substrate with an etching solution and the second means for treating the substrate with a cleaning liquid in such a way that they are able to wipe off liquids on the surface of the substrate.

12. Device for treating substrates which have prestructured zinc oxide layers arranged on rigid or flexible supports, in which the ZnO is treated with an etching solution and then with a cleaning liquid and dried, and the treatment with the etching solution and the cleaning liquid as well as the drying occur whilst the substrate is being conveyed through a device,
**characterised in that**
a continuous system is used as the device, which has resistant materials depending on the etching solution.

13. Process according to the foregoing claim 12,
in which several substrates are treated consecutively.

14. Process according to one of the foregoing claims 12 to 13,
in which the substrate is conveyed through the device by means of transport rollers.

15. Process according to one of the foregoing claims 12 to 14,
in which a substrate is treated with a prestructured zinc oxide surface of more than 0.16 m², particularly of more than 0.5 m².

16. Process according to one of the foregoing claims 12 to 15,
in which the treatment of the substrate with an etching solution and a cleaning liquid is effected by means of atomiser nozzles.

17. Process according to one of the foregoing claims 12 to 16,
in which the substrate is conveyed horizontally upwards with the TCO layer through the device and the treatment an etching solution and a cleaning liquid is effected by means of atomiser nozzles from above on the surface.

18. Process according to one of the foregoing claims 12 to 17,
in which the etching solution and/or cleaning liquid is or are temperature controlled.

19. Process according to one of the foregoing claims 12 to 18,
in which a device is selected, in which all the parts which come into contact with the etching solution are made of acid-resistant plastic or of titanium.

20. Process according to one of the foregoing claims 12 to 19,
in which the entire device is made acid and alkali resistant.

## Revendications

1. Dispositif pour le traitement de substrats dotés de couches d'oxyde de zinc pré-structurées disposées sur des supports rigides ou flexibles, avec un premier moyen pour le traitement du substrat avec un liquide de gravure, un deuxième moyen pour le traitement du substrat avec un liquide de nettoyage et un autre moyen pour le transport du substrat du premier au deuxième moyen, ainsi qu'un moyen pour le séchage du substrat après le traitement de nettoyage,
**caractérisé**
**en ce que** le dispositif est une installation continue dotée de matériaux résistants en fonction du milieu de gravure choisi.

2. Dispositif selon la revendication 1,
**caractérisé**
**en ce que** toutes les pièces entrant en contact avec la solution de gravure sont en matière plastique résistante aux acides ou en titane.

3. Dispositif selon l'une des revendications précédentes,
**caractérisé**
**en ce que** l'ensemble du dispositif est résistant aux acides et aux lessives.

4. Dispositif selon l'une des revendications précédentes,
comportant des rouleaux convoyeurs en tant qu'autre moyen.

5. Dispositif selon l'une des revendications précédentes,
comportant un entraînement apte à entraîner les rouleaux convoyeurs.

6. Dispositif selon l'une des revendications précédentes,
apte à traiter des substrats avec une surface d'oxyde de zinc supérieure à 0,16 m², en particulier supérieure à 0,5 m².

7. Dispositif selon l'une des revendications précédentes,
où les rouleaux convoyeurs sont disposés de manière à permettre le transport horizontal d'un substrat.

8. Dispositif selon l'une des revendications précédentes,
comportant une ou plusieurs buses d'aspersion en tant que premier ou que deuxième moyen.

9. Dispositif selon la revendication 8,
où la buse d'aspersion est disposée au-dessus des rouleaux convoyeurs.

10. Dispositif selon l'une des revendications précédentes,
comportant au moins une buse d'aspersion à température équilibrable en tant que premier ou que deuxième moyen.

11. Dispositif selon l'une des revendications précédentes,
où des rouleaux sont disposés entre le moyen pour le traitement du substrat avec un liquide de gravure et le deuxième moyen pour le traitement du substrat avec un liquide de nettoyage, de manière à pouvoir racler les liquides à la surface du substrat.

12. Procédé pour le traitement de substrats dotés de couches d'oxyde de zinc pré-structurées disposées sur des supports rigides ou flexibles, où l'oxyde de zinc est traité par un milieu de gravure puis par un liquide de nettoyage avant d'être séché, et où le traitement par le milieu de gravure, le liquide de nettoyage ainsi que le séchage sont effectués pendant que le substrat est transporté par un dispositif,
**caractérisé**
**en ce qu'**une installation continue est utilisée comme dispositif, dotée de matériaux résistants en fonction du milieu de gravure.

13. Procédé selon la revendication 12,
où plusieurs substrats sont traités successivement.

14. Procédé selon l'une des revendications 12 à 13,
où le substrat est transporté dans le dispositif au moyen de rouleaux convoyeurs.

15. Procédé selon l'une des revendications 12 à 14,
où est traité un substrat avec une surface d'oxyde de zinc pré-structurée supérieure à 0,16 m², en particulier supérieure à 0,5 m².

16. Procédé selon l'une des revendications 12 à 15,
où le traitement du substrat par un milieu de gravure et
un liquide de nettoyage est réalisé au moyen de buses d'aspersion.

17. Procédé selon l'une des revendications 12 à 16,
où le substrat avec la couche TCO est transporté horizontalement vers le haut dans le dispositif, et où le traitement par un milieu de gravure et un liquide de nettoyage est appliqué par le haut sur la surface au moyen de buses d'aspersion.

18. Procédé selon l'une des revendications 12 à 17,
où la température du milieu de gravure et/ou du liquide de nettoyage est équilibrée.

19. Procédé selon l'une des revendications 12 à 18,
où un dispositif est sélectionné, où toutes les pièces entrant en contact avec la solution de gravure sont en matière plastique résistante aux acides ou en titane.

20. Procédé selon l'une des revendications 12 à 19,
où l'ensemble du dispositif est résistant aux acides et aux lessives.
